# EUROPÄISCHE PATENTSCHRIFT

(11) **EP 0 268 830 B1**
(45) Veröffentlichungstag und Bekanntmachung des Hinweises auf die Patenterteilung: **19.01.1994**
(21) Anmeldenummer: 87115451.4
(22) Anmeldetag: 21.10.1987
(51) Int. Cl.: G06K 19/06, G06K 19/00

(54) **Datenträger mit integriertem Schaltkreis und Verfahren zur Herstellung desselben**
Data carrier with integrated circuit and process for making the same
Support de données avec circuit intégré et procédé pour sa fabrication

(30) Priorität: 20.11.1986 DE 3639630
(43) Veröffentlichungstag der Anmeldung: 01.06.1988
(60) Teilanmeldung: 93103992.9
(73) Patentinhaber: GAO Gesellschaft für Automation und Organisation mbH, 81307 München (DE)
(72) Erfinder: Haghiri, Yahya, Dipl.-Ing., D-8000 München 40 (DE)
(74) Vertreter: Klunker . Schmitt-Nilson . Hirsch

(56) Entgegenhaltungen:
- EP-A- 0 189 039
- DE-A- 3 338 597
- DE-C- 3 151 408
- GB-A- 2 166 589

## Beschreibung

Die Erfindung betrifft einen Datenträger mit mindestens einem IC-Baustein zur Verarbeitung elektrischer Signale, wobei der IC-Baustein auf einem im Vergleich zur Fläche des Datenträgers kleinen Substrat angeordnet ist, über Leiterbahnen mit ebenfalls auf dem Substrat vorgesehenen Kontaktelementen, die die Kommunikation des IC-Bausteins mit entsprechenden Automaten ermöglichen, in Verbindung steht und in einer Aussparung einer mittleren Kartenschicht angeordnet ist.

Ein Datenträger der o.g. Art ist beispielsweise aus der DE-OS 33 38 597 bekannt.

Bei dem bekannten Datenträger wird das den IC-Baustein, die Leiterbahnen und die Kontaktflächen tragende Substrat derart unter Anwendung von Wärme und Druck in eine mehrschichtige Ausweiskarte einlaminiert, daß der IC-Baustein im Inneren der Karte liegt, während die Kontaktflächen mit der Kartenoberfläche bündig abschließen.

Die in der DE-OS 33 38 597 verwendete Bauform für den integrierten Schaltkreis ist ein sogenanntes Mikropack. Das Substrat besteht dabei im allgemeinen aus einem Material (z.B. Polyimid), das sich mit den üblichen Kartenmaterialien nicht verbindet. Es wird daher ein Schmelzkleber bzw. eine Schmelzkleberfolie eingesetzt, um die unterschiedlichen Kunststoffmaterialien unter Anwendung von Wärme und Druck miteinander verbinden zu können.

Wenn auch die in der DE-OS 33 38 597 erwähnte Schmelzkleberfolie als nachgiebige weiche Schicht in Form einer Pufferzone eine für den Schaltkreis schützende Wirkung aufbringt, hat sich doch in der Praxis gezeigt, daß diese schützende Wirkung vor allem bei integrierten Schaltkreisen mit größeren Abmessungen, die aufgrund ihrer Abmessungen beim Kartengebrauch stärkeren Biegekräften ausgesetzt sind, nicht den gewünschten Erfordernissen entspricht. Dies ist unter anderem auch darauf zurückzuführen, daß die Schmelzkleberfolie vergleichsweise dünn ausgebildet sein muß, wodurch die schützende Wirkung als Pufferzone zwangsläufig eingeschränkt wird. Bei dickeren Folien kann nämlich nicht vermieden werden, daß während des Zusammenpressens der Kartenschichten an den Randbereichen des Substrats Schmelzklebermaterial austritt, an die Oberfläche der Karte gelangt und das Erscheinungsbild der Karte beeinträchtigt, wenn es nicht in einem zusätzlichen Verfahrensschritt entfernt wird. Die Schmelzkleberfolie wird also in ihrer Dicke derart optimiert, daß bei guter Haftung, bezogen auf die gesamte Fläche des Substrats, kein Klebermaterial an den offenen Stellen im Randbereich des Substrats austritt. Damit bleibt aber bei vertretbarem technischen Aufwand kein Spielraum hinsichtlich der Optimierung der Schmelzkleberfolie als schützende Pufferzone.

Die Aufgabe der Erfindung besteht deshalb darin, ohne nennenswerten technischen Mehraufwand einen Datenträger mit integriertem Schaltkreis vorzuschlagen, bei dem auch Schaltkreise mit größeren Abmessungen den mechanischen Beanspruchungen in der Praxis standhalten.

Gelöst wird diese Aufgabe durch die im Anspruch 1 angegebenen Merkmale.

In einer bevorzugten Ausführungsform der Erfindung werden die einzelnen Schichten eines Datenträgers und das den IC-Baustein tragende Substrat unter Anwendung von Wärme und Druck miteinander verpreßt. Dabei wird das den IC-Baustein, die Leiterbahnen und die Kontaktflächen tragendes Substrat derart in das Laminat eingebettet, daß der IC-Baustein im Inneren des Datenträgers angeordnet ist, während die Kontaktflächen an dessen Oberfläche liegen. Um das Substrat mit den Materialien des Datenträgers verbinden zu können, wird eine Schmelzkleberfolie eingesetzt. Zusätzlich ist nun als separates Element zwischen dem Substrat und der Schmelzkleberfolie ein Folienstreifen vorgesehen, der etwa die Breite und mindestens die Länge des IC-Bausteins hat und der aus einem Material besteht, das ein gegenüber dem umgebenden Materialien des Datenträgers höheres Deformierungsvermögen aufweist.

Mit dem Einsatz dieses Folienstreifens wird es möglich, auch für Schaltkreise mit größeren Abmessungen eine wirksame Pufferzone vorzusehen, ohne die Dicke der Schmelzkleberfolie an die Größe des Bausteins anpassen zu müssen. Schmelzkleberfolie und der die schützende Pufferzone bildende Folienstreifen können unabhängig voneinander im Hinblick auf ihre jeweiligen Funktionen optimiert werden. Während die Schmelzkleberfolie derart gewählt wird, daß bei guter Haftung der zu verbindenen Elemente kein Klebermaterial an den offenen Stellen im Randbereich des Substrats austritt, kann der Folienstreifen als separat eingesetztes Element in seinen Abmaßen und physikalischen Eigenschaften derart optimiert werden, daß auch größere IC-Bausteine gegenüber mechanischen Belastungen wirksam geschützt sind.

Trotz dieser Vorteile ist der Einsatz des Folienstreifens mit keinem nennenswerten Mehraufwand verbunden Die zum Einbau in Ausweiskarten geeigneten integrierten Schaltkreise werden im allgemeinen auf Filmstreifen montiert vom Halbleiterhersteller geliefert. Um aus dem Filmstreifen entsprechend ausgestanzte Substrate, wie in der DE-OS 33 38 597 beschrieben, in Ausweiskarten einbauen zu können, ist, wie erwähnt, eine Klebeschicht, beispielsweise eine Schmelzkleberfolie erforderlich. Die Verbindung von Substrat und Schmelzkleberfolie geschieht vorzugsweise vor der Kartenherstellung, wobei beispielsweise in einer Rollen-Kaschiereinrichtung Substrat und Schmelzkleberfolie, jeweils von einer eigenen Rolle abgewickelt, zusammengeführt werden und unter Einwirkung von Wärme und Druck miteinander verbunden werden. Verfahrenstechnisch gesehen erfordert die Anordnung eines zusätzlichen Folienstreifens auf dem IC-Baustein keinen zusätzlichen Aufwand, da dieser Streifen, ebenfalls von einer Rolle abgewickelt, gleichzeitig mit der Schmelzkleberfolie auf den Substratfilm, der den integrierten Baustein trägt, aufgebracht werden kann. Der zusätzliche Folienstreifen wird zwischen Substrat und Schmelzkleberberfolie eingeschlossen. Auch der zusätzliche Materialaufwand bezogen auf ein Substrat bzw. auf einen Datenträger ist unter Berücksichtingung der Gesamtkosten eines Datenträgers praktisch ohne Bedeutung.

Gemäß einer weiteren Ausführungsform der Erfindung besteht der Folienstreifen aus einem Material, das neben einem hohen elastischen Deformierungsvermögen eine gegenüber den Materialien des Datenträgers niedrigere Erweichungstemperatur aufweist und sich außerdem während des Laminiervorgangs mit den in der Umgebung befindlichen Materialien (wie beispielsweise Schmelzkleberfolie, Substratfolie und auch IC-Baustein) nicht verbindet. Da also der Folienstreifen während des Laminierens plastisch deformierbar ist und keine Verbindung mit den ihn umgebenden Materialien eingeht, können IC-Baustein und Leiterbahnen einerseits verspannungsfrei eingebettet werden und sich andererseits bei starken Deformationen des Datenträgers bei Gebrauch innerhalb des Laminats in gewissen Grenzen bewegen und somit den durch die Deformation bedingten Verspannungen im Laminat ausweichen. Ein Material, das die genannten Eigenschaften aufweist, ist beispielsweise Polyäthylen.

Weitere Vorteile und Weiterbildungen der Erfindung ergeben sich aus den Unteransprüchen sowie aus der nachfolgenden Beschreibung einiger Ausführungsbeispiele anhand der Figuren.

Es zeigen:
- Fig. 1: eine Ausweiskarte in der Aufsicht,
- Fig. 2: die Ausweiskarte nach Fig. 1 in einer Schnittdarstellung vor dem Laminieren,
- Fig. 3: die Ausweiskarte nach Fig. 1 in einer Schnittdarstellung nach dem Laminieren,
- Fig. 4: eine Vorrichtung zur Herstellung eines Trägerelements mit Folienstreifen,
- Fig. 5: eine Schnittdarstellung der Vorrichtung aus Fig. 4 entlang der Linie A-B,
- Fig. 6: die in der Vorrichtung gemäß Fig. 4 hergestellten Trägerelemente in der Aufsicht,
- Fig. 7: eine weitere Ausführungsform eines in der Vorrichtung gemäß Fig. 4 hergestellten Trägerelements,
- Fig. 8: eine Ausweiskarte und ein Trägerelement vor dem Zusammenfügen der Einzelelemente,
- Fig. 9 und 10: eine Ausführungsform eines Trägerelements in der Aufsicht und im Schnitt und
- Fig. 11 und 12: eine weitere Ausführungsform eines Trägerelements in der Aufsicht und im Schnitt.

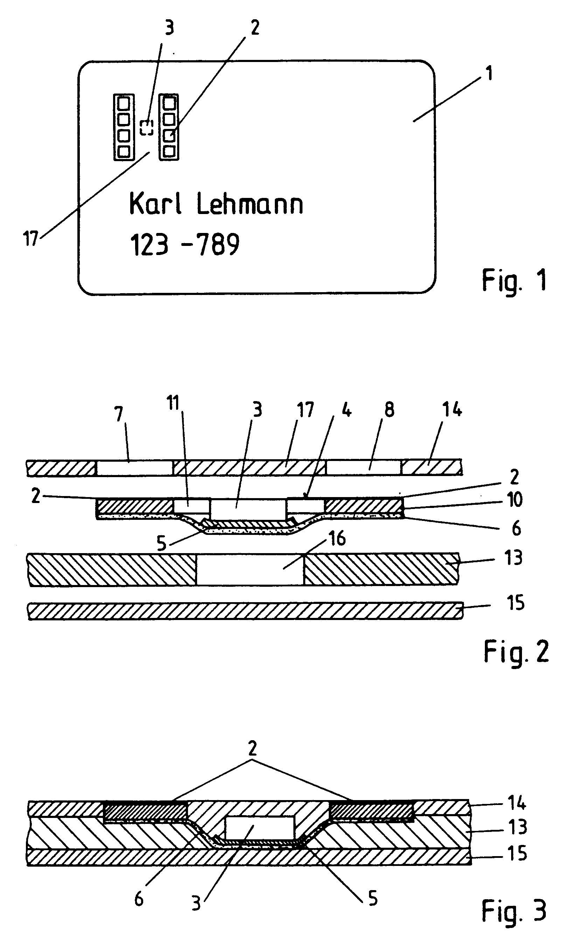

Die Fig. 1 zeigt eine Ausweiskarte 1 mit einem im Kartenkern eingebetteten IC-Baustein 3, der über Leiterbahnen mit den äußeren Kontaktflächen 2, die an der Oberfläche der Karte liegen, elektrisch verbunden ist. In einer bevorzugten Ausführungsform besteht die Karte aus drei Schichten (siehe Fig. 2 und 3), einer Kartenkernschicht 13, mit einer öffnung 16 für den IC-Baustein 3 und zwei Deckfolien 14, 15, wobei die Deckfolie 14 zwei Aussparungen 7 und 8 aufweist. Die Aussparungen sind so dimensioniert, daß sie in dem gezeigten Ausführungsbeispiel jeweils eine Gruppe, bestehend aus vier Kontaktflächen, aufnehmen können. Die untere Deckfolie 15 schließt die Ausweiskarte rückseitig ab. Zwischen der Kernschicht 13 und der Deckfolie 14 befindet sich das sogenannte Trägerelement, bestehend aus dem IC-Baustein 3, den Leiterbahnen 4, den Kontaktflächen 2 und dem Trägersubstrat 10. Der IC-Baustein 3 ist in einer Aussparung 11 des Substrats 10 mit den in die Aussparung hineinragenden Enden der Leiterbahnen 4 verbunden und wird in dem Fenster lediglich durch die Befestigung der Leiterbahnen mit den entsprechenden Anschlußpunkten des Bausteins gehalten. Diese Art der Besfestigung bzw. Positionierung von Halbleiterbauelementen mit Leiterbahnen, die aus einer leitenden Beschichtung des Substrats geätzt sind, ist seit langem bekannt und hat sich in der Praxis bewährt (siehe dazu auch Siemens-Bauteile-Report 16 (1978), Heft 2, Seite 40 - 44).

Zur Fixierung des Trägerelements im Kartenaufbau ist das Trägerelement mit einer Schmelzkleberfolie 6 unterlegt. Diese Schmelzkleberfolie dient zur Verbindung des Substrats 10, das z. B. aus Polyimid besteht, mit dem Material der Ausweiskarte (beispielsweise PVC), so daß sich diese Schichten während des Zusammenpressens unter Wärme und Druck miteinander verbinden.

Erfindungsgemäß wird zwischen der Schmelzkleberfolie 6 und dem IC-Baustein 3 ein Folienstreifen 5 eingebracht, der mindestens die Abmaße des IC-Bausteins aufweist und dessen Bodenfläche abdeckt. Der Folienstreifen besteht aus einem Material mit hohem elastischen Deformierungsvermögen, so daß sich IC-Baustein und Leiterbahnen auch bei starken Deformationen der Karte innerhalb des Kartenlaminats in gewissen Grenzen bewegen und den durch die Deformation bedingten Verspannungen im Kartenlaminat ausweichen. Vorzugsweise hat das Material des Folienstreifens neben dem hohen elastischen Deformierungsvermögen einen gegenüber den eingesetzten Kartenmaterialien geringen Erweichungspunkt. Dadurch ist das Material während des Laminierens plastisch deformierbar, was eine verspannungsfreie Einbettung von IC-Baustein und Leiterbahnen ermöglicht. Es hat sich außerdem gezeigt, daß die Schutzwirkung noch verbessert werden kann, wenn man ein Material wählt, z. B. Polyäthylen, das nicht nur ein, z. B. gegenüber PVC, geringes Elastizitätsmodul E (PE) = 200 - 300 N/mm², E (PVC) = 3000 N/mm² und einen geringeren Erweichungspunkt aufweist, sondern sich auch während des Laminiervorgangs mit den in der Umgebung vorhandenen Materialien wie Schmelzkleberfolie 6, Substrat 10 und auch IC-Baustein 3 nicht verbindet. Die hierdurch noch verbesserte Schutzwirkung für den Schaltkreis ist vermutlich auf die Beweglichkeit des Folienstreifens im Karteninnern zurückzuführen, die nicht durch Haftwirkung zu benachbarten Elementen beeinträchtigt wird.

Die beschriebene, vorteilhafte Einbettungstechnik ist ohne nennenswerten technischen Mehraufwand realisierbar, wenn das Trägerelement bereits vor seiner Einlagerung in eine Ausweiskarte mit einem Folienstreifen ausgestattet wird.

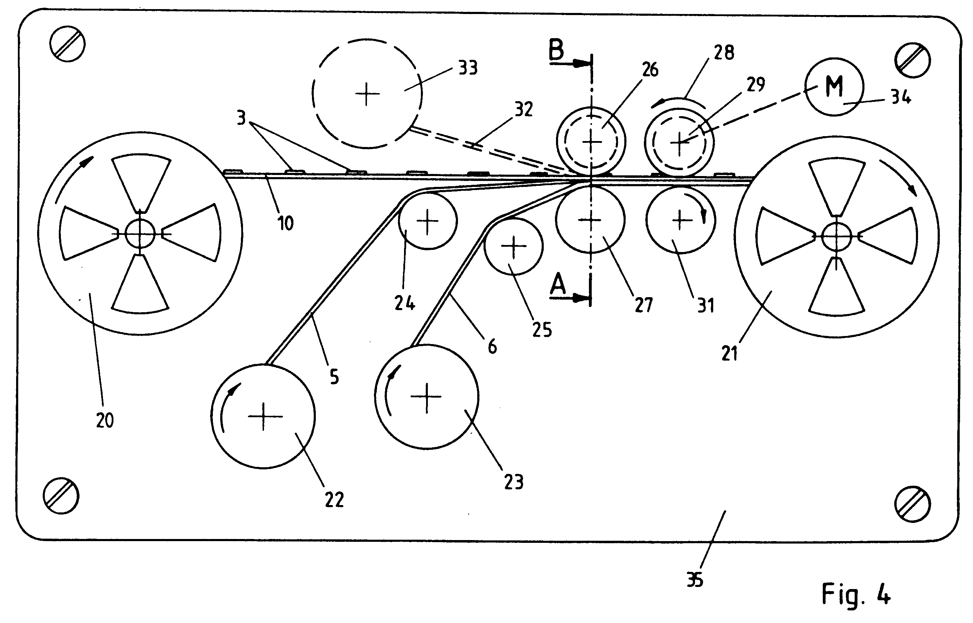

Eine entsprechende Vorrichtung zur Herstellung solcher Trägerelemente zeigt die Fig. 4. Die hier in stark schematisierter Form gezeigte Vorrichtung unfaßt im wesentlichen eine sogenannte rollenkaschiereinrichtung, bestehend aus einer Heizwalze 26 und einer Andruckwalze 27 sowie einer Antriebseinrichtung, bestehend aus einer mit einem Motor 34 verbundenen Antriebswalze 29 und einer Gegenwalze 31. Der Motor dreht die Antriebswalze 29 in Richtung des Pfeils 28. Die zu verbindenden Film- bzw. Folienstreifen werden von Vorratsrollen 20, 22, 23 abgewickelt und nach dem Passieren der Rollenkaschier- und Antriebseinrichtung auf eine Speicherrolle 21 aufgewickelt. Diese und weitere im einzelnen noch später erläuterte Elemente sind alle auf einer Montageplatte 35 befestigt.

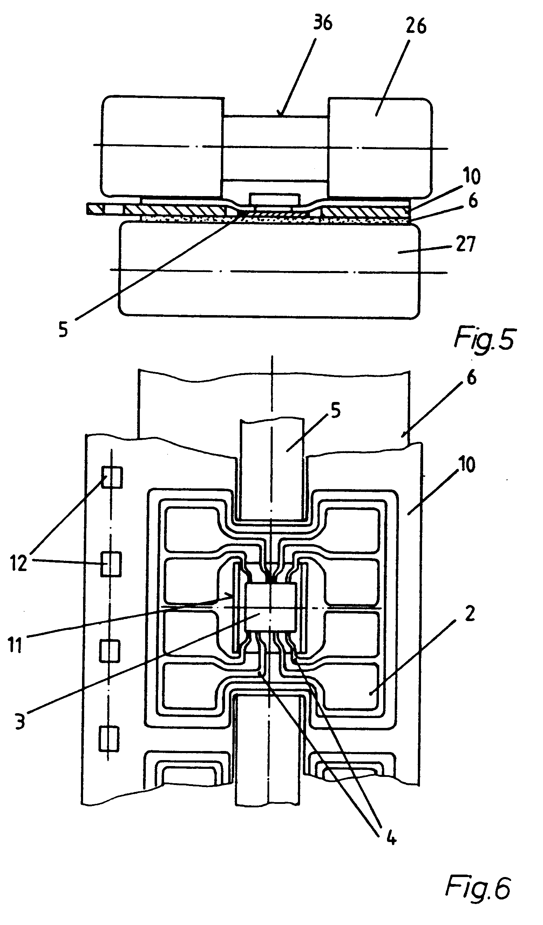

Das Ausgangsprodukt für die Herstellung von Trägerelementen ist ein Substratfilm 10, auf dem in regelmäßigen Abständen, in sogenannter TAB-Technik (Tape Automated Bonding), IC-Bausteine 3 montiert sind. Der mit den IC-Bausteinen 3 bestückte Film 10 ist, wie allgemein üblich, auf einer Rolle 20 aufgewickelt. Die Schmelzkleberfolie 6 wird von einer Vorratsrolle 23 über eine Umlenkrolle 25 gemeinsam mit dem Substratfilm 10 zwischen Heiz- und Andruckwalze 26, 27 geführt. Zwischen der Heizwalze 26 und der Andruckwalze 27 wird die Schmelzkleberfolie 6 unter Einwirkung von Wärme und Druck mit dem Substratfilm 10 verbunden. Wie die Fig. 5 in einer Schnittdarstellung zeigt, ist die Heizwalze 26 mittig mit einer umlaufenden Aussparung 36 versehen, so daß beim Durchlauf des mit den IC-Bausteinen 3 bestückten Substratfilms 10 die Bausteine frei von mechanischen und thermischen Belastungen sind. Die Schmelzkleberfolie 6 wird dabei entlang der in Transportrichtung verlaufenden Randbereiche mit dem Substratfilm 10 verbunden. Der gemäß der Erfindung zwischen dem IC-Baustein und der Schmelzkleberfolie 6 eingelagerte Folienstreifen 5 wird von einer Vorratsrolle 22 abgewickelt und über die Umlenkrolle 24 im Bereich von Heizund Gegendruckwalze zwischen Schmelzkleberfolie 6 und Substratfilm 10 geführt. Dieser Folienstreifen wird nicht mit den umgebenden Materialien verbunden, sondern lediglich durch den Verbund von Schmelzkleberfolie 6 und Substratfilm 10 in der durch die Einführung vorgegebenen Lage eingeschlossen. Das Folienlaminat durchläuft nach dem Verschmelzen die Antriebs- und Gegendruckwalze 29, 31. Hier wird die Schmelzkleberfolie nochmals unter gleichzeitiger Abkühlung an den Substratfilm angepreßt und damit endgültig fixiert. Das fertiggestellte Laminat wird schließlich auf die Speicherrolle 21 aufgewickelt.

Das Endprodukt ist in der Fig. 6 in der Aufsicht dargestellt. Die Fig. zeigt den Substratfilm 10 mit an seiner Oberfläche liegenden Kontaktflächen 2 und den Leiterbahnen 4, die zu dem in einer Aussparung liegenden IC-Baustein 3 führen. Längs einer Seitenkante ist der Substratfilm 10 mit Perforationslöchern 12 versehen, die auch in der oben beschriebenen Vorrichtung benutzt werden können, um den Substratfilm 10 während der einzelnen Bearbeitungsvorgänge exakt zu transportieren. Der Fig. 6 sind die Abmessungen sowie die Lage des zwischen der Schmelzkleberfolie 6 und dem Substratfilm 10 eingelagerten Folienstreifens 5 zu entnehmen. Der Folienstreifen 5 hat etwa die Breite des IC-Bausteins und erstreckt sich aber über die gesamte Länge des Substratfilms 10. Vorzugsweise werden die zum IC-Baustein 3 in die Aussparung 11 verlaufenden Leiterbahnen 4 derart geführt, daß sie ebenfalls auf dem durchlaufenden Folienstreifen 5 liegen und damit entsprechend geschützt sind.

Wie gezeigt, kann der den IC-Baustein 3 sowie die Leiterbahnen 4 schützende Folienstreifen 5, verfahrenstechnisch gesehen, ohne Mehraufwand zwischen Schmelzkleberfolie 6 und Substratfilm 10 plaziert werden.

Bei der in der Fig. 1 bzw. in der Fig. 3 gezeigten Ausweiskarte werden die einzelnen Kartenschichten unter Anwendung von Wärme und Druck miteinander verbunden. Während des Laminierprozesses wird das Substrat mit allen Bauteilen derart in das Kartenlaminat eingelagert, daß der IC-Baustein etwa in der Mitte des Kartenlaminats liegt, während die Kontaktflächen bündig mit der Kartenoberfläche abschließen. Der zwischen den Kontaktbereichen verlaufende Steg 17 aus dem Material der Deckfolie 14 sorgt u. a. dafür, wie auch in der DE-OS 33 38 597 beschrieben, daß der IC-Baustein in die Aussparung 16 der Kernschicht 13 gedrückt wird.

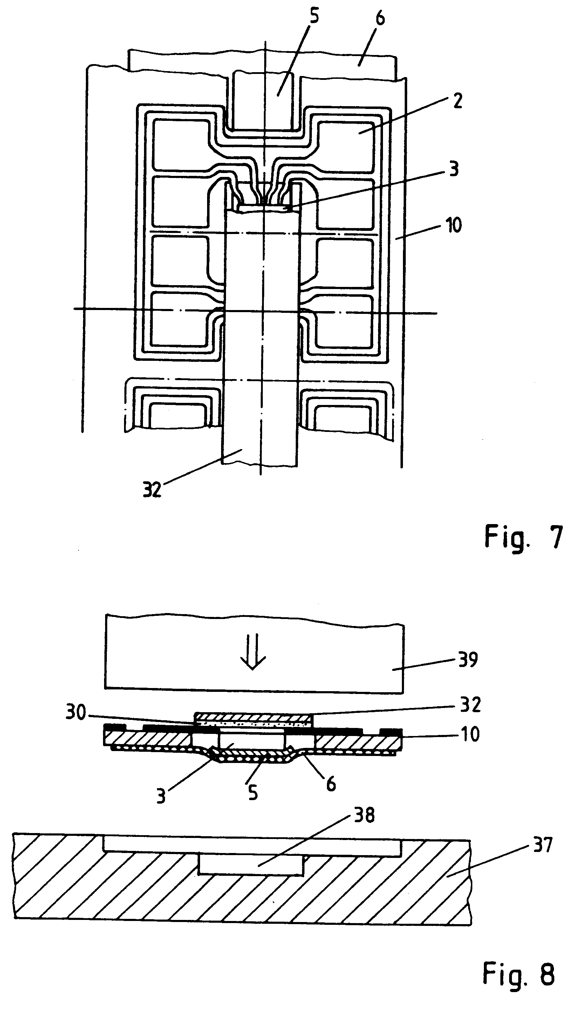

Gemäß anderer bekannt gewordener Einbautechniken wird das Substrat beispielsweise in eine vorbereitete Aussparung einer fertiggestellten Ausweiskarte eingesetzt. Da in diesem Fall keine weitere Deckschicht vorgesehen ist, muß, sofern die sogenannte Mikropack-Bauform beibehalten werden soll, das Substrat auf der Seite, auf der sich die Kontaktflächen befinden, im Bereich des IC-Bausteins auf andere Weise abgedeckt und damit geschützt werden. Eine weitere Ausführungsform der Erfindung besteht deshalb darin, mittig auf dem Substrat 10, wie in Fig. 7 und 8 gezeigt, einen Folienstreifen 32 aufzubringen. Auch dieser Folienstreifen kann ähnlich dem oben geschilderten Verfahren auf einfache Weise mit der in der Fig. 4 gezeigten Vorrichtung auf das Substrat aufgebracht werden. Dazu ist lediglich eine weitere Vorratsrolle 33 vorzusehen (in der Fig. 4 strichliert gezeichnet), von der ein entsprechender Folienstreifen 32 abgewickelt und zwischen Heiz- und Andruckwalze 26, 27 geführt wird. Zur Befestigung des Folienstreifens 32 auf der Substratfolie 10 kann dieser mit einer Klebeschicht 30 versehen werden. Der Folienstreifen 32 wird vorzugsweise dem jeweiligen Kartenmaterial angepaßt, besteht also beispielsweise aus PVC, das entsprechend dem jeweiligen Kartendesign eingefärbt oder bedruckt ist.

Zum Einbau des letztgenannten Substrats in eine Ausweiskarte wird die fertiggestellte Karte (37) mit einer Aussparung 38 versehen, die den Abmessungen des Substrats angepaßt ist (Fig. 8). Das Substrat wird beispielsweise mit einem Heizstempel 39 mit dem Kartenkörper 37 verbunden. Durch den mittig das Substrat durchziehenden Folienstreifen 32 ruht der IC-Baustein gegen äußere Einflüsse geschützt in der Mitte des Kartenkörperlaminats, während die Kontaktflächen offen zugängig an der Kartenoberfläche liegen.

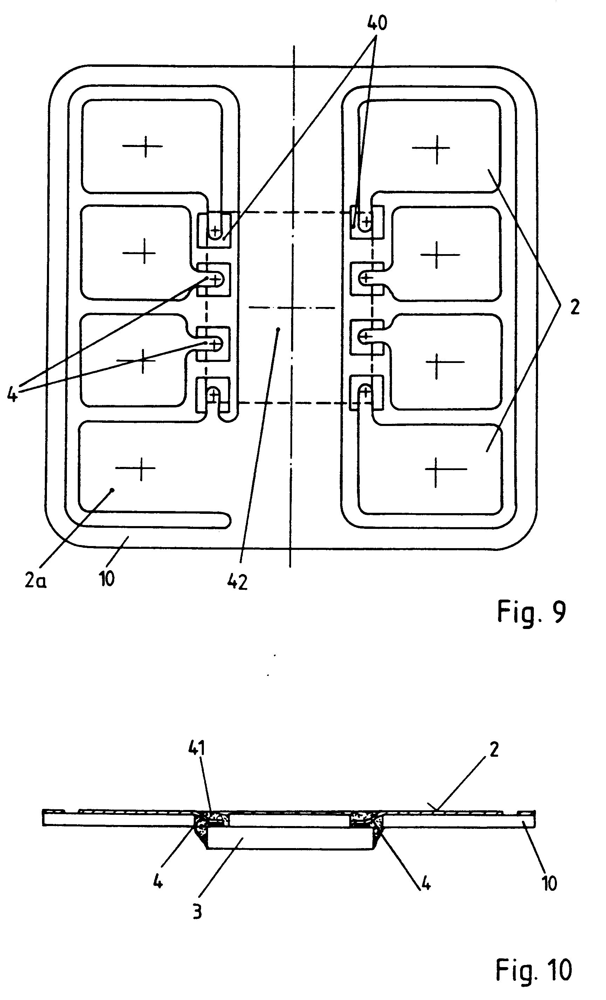

Die Fig. 9 und 10 zeigen eine Ausführungsform eines zum Einbau in Ausweiskarten geeigneten Substrats, wobei der IC-Baustein 3 nicht in einer Aussparung des Substrats 10 liegt, sondern auf der den Kontaktflächen gegenüberliegenden Seite abgedeckt vom Material des Substrats (Fig. 10). Das Substrat weist mehrere Aussparungen 40 auf, durch die die Leiterbahnen 4 laufen, die den IC-Baustein 3 elektrisch mit den Kontaktflächen 2 verbinden. Das gesamte Substrat ist mit einer leitenden Beschichtung 42 versehen, aus der die Kontaktflächen 2 mit den zu den Aussparungen führenden Leiterbahnen ausgeätzt sind. Die Kontaktflächen sind daher rundum von leitendem Material umgeben, das vorzugsweise mit dem Massenkontakt 2a verbunden ist, um den Schaltkreis in an sich bekannter Weise gegen elektrostatische Ladungen zu schützen.

Der Schnittdarstellung in Fig. 10 kann man entnehmen, daß die Aussparungen 40 mit einem geeigneten Harz 41 gefüllt sind, um die Verbindungsstelle zwischen dem jeweiligen Leiterbahnende und dem IC-Baustein gegen Umwelteinflüsse und mechanischen Belastungen zu schützen.

In dem gezeigten Ausführungsbeispiel ist jedem Anschlußpunkt des Bausteins und damit jeder Leiterbahn eine Aussparung 40 zugeordnet. Es ist auch möglich, je nach Leiterbahnführung zwei oder auch mehrere Leiterbahnen gemeinsam durch jeweils eine Aussparung auf die Anschlußpunkte des Bausteins zu führen.

Das in den Fig. 9 und 10 gezeigte Substrat hat den Vorteil, daß es unter Beibehaltung der seit langem erprobten und damit bewährten TAB-Technik (siehe auch Siemens Bauteile-Report) ohne zusätzliche Maßnahmen mit den oben geschilderten Einbautechniken in Ausweiskarten eingesetzt werden kann. Bei der im Zusammenhang mit den Fig. 1 - 3 erläuterten Einbautechnik kann der Mittelsteg 17 der Deckfolie entfallen. Bei der im Zusammenhang mit der Fig. 8 erläuterten Einbauvariante kann man auf den Folienstreifen 32 verzichten.

Zum Einbau des Substrats kann wiederum eine Schmelzkleberfolie verwendet werden. Ebenso kann auch bei diesem Substrat zwischen der Schmelzkleberfolie und dem IC-Baustein ein zusätzlicher Folienstreifen mit den bereits beschriebenen Eigenschaften eingesetzt werden.

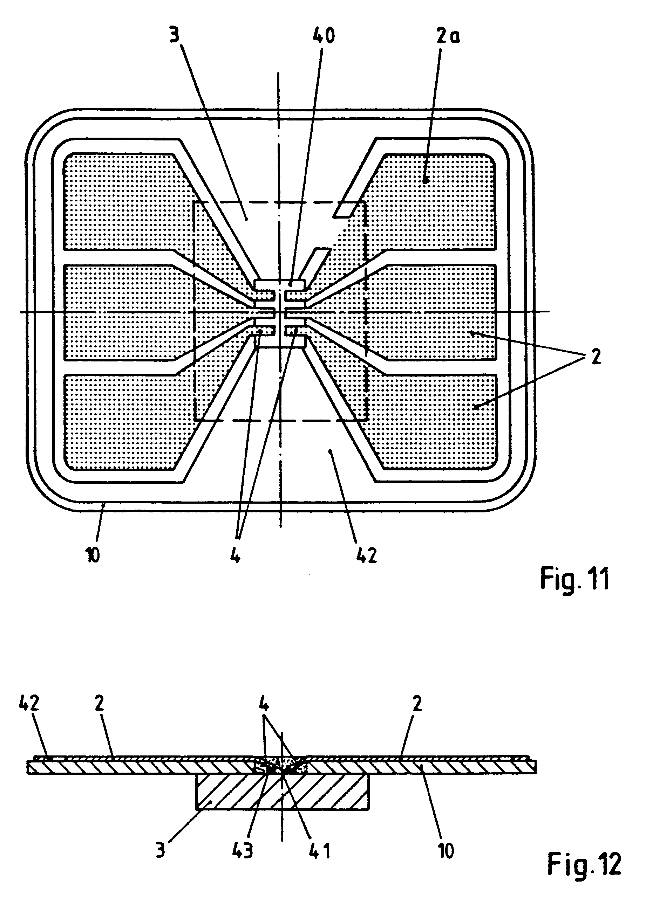

Die Fig. 11 und 12 zeigen schließlich eine weitere Ausführungsform eines Trägerelements für integrierte Schaltkreise, welches im wesentlichen dadurch gekennzeichnet ist, daß die Anschlußpunkte 43 des integrierten Schaltkreises 3 nicht, wie üblich und in den Fig. 10 und 11 gezeigt, im Randbereich der Chipfläche liegen.

Bei dem in den Fig. 11 und 12 beispielhaft gezeigten Trägerelement liegen die Anschlußpunkte 43 des Schaltkreises, auf die die Enden der Leiterbahnen 4 durch eine Aussparung 40 in der Folie 10 geführt sind, im Zentrum der Schaltkreisfläche. Diese Ausführungsform hat mehrere Vorteile.

Das Ausfüllen des Hohlraums 40 mit einem geeigneten Harz oder Silikon ist technisch einfacher zu handhaben, weil der zu füllende Hohlraum in seinem Volumen in nur engen Toleranzen variiert.

Drückt man während des Füllens den Schaltkreis gegen den Film 10, so daß der Schaltkreis die Aussparung 40 einseitig abschließt, liegt ein in seinem Volumen definierter Hohlraum 40 vor, der bei einmal eingestellter Dosierung im Fertingungsprozeß auf einfache Weise gleichmäßig gefüllt werden kann. Auch ein geringer Spalt zwischen Schaltkreis und Film, der während des Füllvorgangs ebenfalls mit dem gewählten Harz oder Silikon ausgefüllt wird, hat auf die Dosierung keinen nachteiligen Einfluß, da die hier einfließende Menge gering ist und bei verschiedenen Trägerelementen nur unwesentlich variiert.

Wählt man zum Ausfüllen des Hohlraums ein transparentes Harz oder Silikongel, dann stört auch ein möglicherweise unregelmäßiger Abschluß der Aussparung an der Oberfläche des Trägerelements nicht das Erscheinungsbild.

Die in den Fig. gezeigte Anordnung der Anschlußpunkte 43 des Bausteins 3 hat weiterhin den Vorteil, daß die gelöteten oder geschweißten Verbindungen zwischen den Leiterbahnenden 4 und den Anschlußpunkten 43 des Bausteins aufgrund ihrer zentralen Lage bei Verbiegungen des Trägerelements bezüglich etwaiger Zug- oder Schwerkräte mechanisch geringer belastet werden, als bei dezentraler Anordnung der Anschlußpunkte im Randbereich des Schaltkreises.

Schließlich hat die gezeigte Plazierung der Anschlußpunkte 43 auf den Schaltkreis den Vorteil, daß die Leiterbahnführung und damit auch das Bondwerkzeug bei unterschiedlicher Schaltkreisgröße unverändert beibehalten werden kann.

## Patentansprüche

1. Datenträger mit mindestens einem IC-Baustein zur Verarbeitung elektrischer Signale, wobei der IC-Baustein auf einem im Vergleich zur Fläche des Datenträgers kleinen Substrat angeordnet ist, über Leiterbahnen mit ebenfalls auf dem Substrat vorgesehenen Kontaktelementen, die die Kommunikation des IC-Bausteins mit entsprechenden Automaten ermöglichen, in Verbindung steht und wobei der IC-Baustein in einer Aussparung einer Kartenschicht angegeordnet ist, dadurch **gekennzeichnet,**
daß der IC-Baustein (3) auf der dem Innern der Karte zugewandten Seite von einem Folienstreifen (5) abgedeckt ist, der etwa die Breite und mindestens die Länge des IC-Bausteins (3) hat und aus einem Material besteht, das ein gegenüber den umgebenden Materialien (13, 14, 15, 37) des Datenträgers höheres Deformierungsvermögen aufweist.

2. Datenträger nach Anspruch 1, dadurch **gekennzeichnet,** daß der Folienstreifen (5) aus einem Material besteht, das neben einem hohen elastischen Deformierungsvermögen eine gegenüber den Materialien des Datenträgers niedrigere Erweichungstemperatur aufweist und mit den in der Umgebung vorhandenen Materialien (13, 14, 15, 37) keine Verbindung eingeht.

3. Datenträger nach Anspruch 2, dadurch **gekennzeichnet,** daß der Folienstreifen (5) aus Polyäthylen besteht.

4. Datenträger nach Anspruch 1, dadurch **gekennzeichnet,** daß das Substrat (10) auf der den Kontaktflächen (2) gegenüberliegenden Seite mit einer Schmelzkleberfolie (6) versehen ist und der Folienstreifen (5) zwischen dem IC-Baustein (3) und der Schmelzkleberfolie (6) eingeschlossen ist.

5. Trägerelement zum Einbau in Datenträger, bestehend aus einem Substrat, das einen IC-Baustein trägt, der über Leiterbahnen mit auf dem Substrat vorgesehenen Kontaktelementen verbunden ist, dadurch **gekennzeichnet,** daß der IC-Baustein (3) mit einem Folienstreifen (5) unterlegt ist, der etwa die Breite und mindestens die Lange des IC-Bausteins (3) hat und aus einem Material besteht, das ein gegenüber PVC höheres Deformierungsvermögen aufweist.

6. Trägerelement nach Anspruch 5 mit einer Schmelzkleberfolie, die auf der den Kontaktflächen gegenüberliegenden Oberfläche des Substrats angeordnet ist, dadurch **gekennzeichnet,** daß der Folienstreifen (5) im Bereich des IC-Bausteins (3) zwischen dem IC-Baustein (3) und der Schmelzkleberfolie (6) vorgesehen ist und über die gesamte Länge des Substrats verläuft.

7. Trägerelement nach Anspruch 6, dadurch **gekennzeichnet,** daß der IC-Baustein (3) in einer Aussparung (11) des Substrats (10) angeordnet ist und die zum IC-Baustein (3) verlaufenden Leiterbahnen (4) im Bereich der Aussparung (11) derart geführt sind, daß sie von dem Folienstreifen (5) unterlegt sind.

8. Trägerelement nach Anspruch 7, dadurch **gekennzeichnet,** daß auf der Oberfläche des Substrats (10), das die Kontaktflächen (2) trägt, ein weiterer Folienstreifen (32) vorgesehen ist, der in etwa die Breite und mindestens die Länge der Aussparung (11) aufweist und zwischen den parallel angeordneten Reihen der Kontaktflächen (2) über das Substrat (10) verläuft.

9. Trägerelement zum Einbau in Datenträger, bestehend aus einem Substrat, das einen IC-Baustein trägt, der über Leiterbahnen mit auf dem Substrat vorgesehenen Kontaktelementen verbunden ist, dadurch **gekennzeichnet,** daß der IC-Baustein (3) auf einer Seite des Substrats (10) angeordnet ist und daß die Leiterbahnen (4) von den Anschlußpunkten (43) des IC-bausteins durch öffnungen (40) im Substrat (10) verlaufen und mit den Kontaktflächen (2) verbunden sind, die auf der dem IC-Baustein (3) gegenüberliegenden Seite des Substrats (10) liegen.

10. Trägerelement nach Anspruch 9, dadurch **gekennzeichnet,** daß die Anschlußpunkte (43) des IC-Bausteins (3) derart auf diesem plaziert sind, daß die öffnungen (40) im Substrat (10) auf der den Kontaktflächen (2) gegenüberliegenden Seite durch den IC-Baustein abgedeckt sind.

11. Trägerelement nach Anspruch 10, dadurch **gekennzeichnet,** daß die Anschlußpunkte (43) im Zentrum der Fläche des IC-Bausteins (3) angeordnet sind.

12. Verfahren zur Herstellung eines Trägerelements nach Anspruch 6, **gekennzeichnet** durch die folgenden Verfahrensschritte:
- Bereitstellen eines mit IC-Bausteinen bestückten Substratfilms,
- Zuführen eines Folienstreifens mit hohem Deformierungsvermögen und mit einer Breit, die etwa der Breite des IC-Bausteins entspricht auf der den Kontaktflächen gegenüberliegenden Seite des Substratfilms im Bereich des IC-Bausteins,
- Zuführen einer Schmelzkleberfolie auf der den Kontaktflächen gegenüberliegenden Seite des Substratfilms, so daß die Schmelzkleberfolie sowohl den Folienstreifen (5) als auch Teile der Oberfläche des Substratfilms überdeckt,
- Fixieren des Folienstreifens durch Verbindung der Schmelzkleberfolie mit dem Substratfilm, wobei die Schmelzkleberfolie zumindest im Randbereich des IC-Bausteins mit den Folien verbunden wird.

13. Verfahren nach Anspruch 12, dadurch **gekennzeichnet,** daß auf der Seite des Substratfilms, die die Kontaktflächen aufweist, ein zusätzlicher Folienstreifen aufgebracht wird, der in etwa die Breite der Aussparung des Substrats hat und zwischen den parallel angeordneten Reihen der Kontaktflächen verläuft.

14. Vorrichtung zur Durchführung des Verfahrens nach Anspruch 12, **gekennzeichnet** durch
- eine Kaschier- (26, 27) und Antriebseinrichtung (29, 31, 34) zum Transport und Verbindung eines mit IC-Bausteinen (3) bestückten Substratfilms (10) mit mindestens einem Folienstreifen,
- eine erste Einrichtung (20) zur Bereitstellung des mit IC-Bausteinen bestückten Substratfilms (10),
- eine zweite Einrichtung (22, 24) die einen ersten Folienstreifen (5) mit hohem Deformierungsvermögen und mit einer Breite, die etwa der Breite des IC-Bausteins (3) entspricht, an den Substratfilm im Bereich der Kaschiervorrichtung (26, 27),zuführt
- eine dritte Einrichtung (23, 25) die einen Schmelzkleberfolie (6) an den Substratfilm (10) im Bereich der Kaschiervorrichtung (26, 27),zuführt
- eine Einrichtung (21) die den mit mindestens einem Folienstreifen versehenen Substratfilm (10) zwischenspeichert.

15. Vorrichtung nach Anspruch 14,
dadurch **gekennzeichnet,**
daß die zweite Einrichtung aus einer Vorrats- und Umlenkrolle (22, 24) besteht, um einen Folienstreifen (5), bestehend aus Polyäthylen der Kaschiervorrichtung (26, 27) zuzuführen.

16. Vorrichtung nach Anspruch 14, dadurch **gekennzeichnet,** daß die dritte Einrichtung aus einer Vorrats-und Umlenkrolle (23, 25) besteht, um die Schmelzkleberfolie (6) der Kaschiervorrichtung (26, 27) zuzuführen.

17. Vorrichtung nach Anspruch 14,
dadurch **gekennzeichnet,**
daß eine vierte Einrichtung (33) vorgesehen ist, die der zweiten und dritten Einrichtung (22, 24, 23, 25) gegenüberliegend angeordnet ist und über die ein weiterer Folienstreifen (32) an den Substratfilm (10) heranführbar ist.

## Claims

1. A data carrier having at least one IC module for processing electrical signals, the IC module being disposed on a substrate which is small compared to the area of the data carrier, communicating via leads with contact elements also provided on the substrate which allow for communication of the IC module with corresponding machines, and said IC module being disposed in a recess in a card layer, **characterized** in that the IC module (3) is covered on the side facing the interior of the card by a film strip (5) which is approximately as wide and at least as long as the IC module (3) and made of a material having higher deformability than the surrounding materials (13, 14, 15, 37) of the data carrier.

2. The data carrier of claim 1, **characterized** in that the film strip (5) is made of a material which not only has high elastic deformability but also has a lower softening temperature than the materials of the data carrier and does not bond with the materials (13, 14, 15, 37) in the surroundings.

3. The data carrier of claim 2, **characterized** in that the film strip (5) is made of polyethylene.

4. The data carrier of claim 1, **characterized** in that the substrate (10) is provided on the side opposite the contact surfaces (2) with a melt adhesive film (6) and the film strip (5) is enclosed between the IC module (3) and the melt adhesive film (6).

5. A carrier element for incorporation in a data carrier, comprising a substrate bearing an IC module connected via leads with contact surfaces provided on the substrate, **characterized** in that the IC module (3) is underlaid with a film strip (5) which is substantially as wide and at least as long as the IC module (3) and is made of a material having higher deformability than PVC.

6. The carrier element of claim 5, having a melt adhesive film disposed on the surface of the substrate opposite the contact surfaces, **characterized** in that the film strip (5) is provided in the area of the IC module (3) between the IC module (3) and the melt adhesive film (6) and extends along the entire length of the substrate.

7. The carrier element of claim 6, **characterized** in that the IC module (3) is disposed in a recess (11) in the substrate (10), and the leads (4) extending to the IC module (3) are directed in the area of the recess (11) in such a way as to be underlaid with the film strip (5).

8. The carrier element of claim 7, **characterized** in that a further film strip (32) is provided on the surface of the substrate (10) bearing the contact surfaces (2), said film strip being substantially as wide and at least as long as the recess (11) and extending across the substrate (10) between the parallel rows of contact surfaces (2).

9. A carrier element for incorporation in data carriers, comprising a substrate bearing an IC module connected via leads with contact surfaces provided on the substrate, **characterized** in that the IC module (3) is disposed on one side of the substrate (10), and the leads (4) extend from the terminals (43) of the IC module through openings (40) in the substrate (10) and are connected with the contact surfaces (2) located on the side of the substrate (10) opposite the IC module (3).

10. The carrier element of claim 9, **characterized** in that the terminals (43) of the IC module (3) are placed thereon in such a way that the openings (40) in the substrate (10) are covered by the IC module on the side opposite the contact surfaces (2).

11. The carrier element of claim 10, **characterized** in that the terminals (43) are disposed in the center of the area of the IC module (3).

12. A method for making the carrier element of claim 6, **characterized** by the following method steps:
providing a substrate film equipped with IC modules,
supplying a film strip with high deformability and a width corresponding substantially to that of the IC module on the side of the substrate film opposite the contact surfaces and in the area of the the IC module,
supplying a melt adhesive film on the side of the substrate film opposite the contact surfaces so that the melt adhesive film covers both the film strip (5) and parts of the surface of the substrate film,
fixing the film strip by connecting the melt adhesive film with the substrate film, the melt adhesive film being connected with the films at least in the edge area of the IC module.

13. The method of claim 12, **characterized** in that an additional film strip is provided on the side of the substrate film having the contact surfaces, said film strip being substantially as wide as the recess in the substrate film and extending between the parallel rows of contact surfaces.

14. An apparatus for carrying out the method of claim 12, **characterized** by:
laminating (26, 27) and driving means (29, 31, 34) for transporting and connecting a substrate film (10) equipped with IC modules (3) with at least one film strip,
first means (20) for providing the substrate film (10) equipped with IC modules,
second means (22, 24) for supplying a first film strip (5) with high deformability and a width corresponding substantially to the width of the IC module (3), to the substrate film in the area of the laminating means (26, 27),
third means (23, 25) for supplying a melt adhesive film (6) to the substrate film (10) in the area of the laminating means (26, 27),
means (21) for intermediately storing the substrate film (10) provided with at least one film strip.

15. The apparatus of claim 14, **characterized** in that the second means comprises supply and deflection rolls (22, 24) for supplying a film strip (5) made of polyethylene to the laminating means (26, 27).

16. The apparatus of claim 14, **characterized** in that the third means comprises supply and deflection rolls (23, 25) for supplying the melt adhesive film (6) to the laminating means.

17. The apparatus of claim 14, **characterized** in that fourth means (33) are disposed opposite the second and third means (22, 24, 23, 25) for directing a further film strip (32) to the substrate film (10).

## Revendications

1. Support de données, comprenant au moins un module de circuits intégrés pour le traitement de signaux électriques, dans lequel ce module de circuits intégrés est disposé sur un substrat relativement petit par rapport à la surface du support de données, et est en communication par des lignes conductrices avec des éléments de contact prévus eux aussi sur le substrat, qui permettent la communication du module de circuits -intégrés avec des machines automatiques correspondantes, et dans lequel le module de circuits intégrés est disposé dans un évidement d'une couche de la carte, **caractérisé** en ce que le module (3) de circuits intégrés est recouvert, sur le côté tourné vers l'intérieur de la carte, par un ruban de film (5) dont la largeur est à peu près à celle du module (3) de circuit intégré et dont la longueur est au moins égale à celle de ce module, et qui se compose d'une matière dont la possibilité de déformation est plus élevée que celle des matières environnantes (13, 14, 15, 37) du support de données.

2. Support de données selon la revendication 1, **caractérisé** en ce que le ruban de film (5) se compose d'une matière qui présente, en plus d'une capacité de déformation élastique élevée, une température de ramollissement plus basse que celle des matières du support de données et qui ne forme aucune combinaison avec les matières (13, 14, 15, 37) se trouvant dans le voisinage.

3. Support de données selon la revendication 2, **caractérisé** en ce que le ruban de film (5) de compose de polyéthylène.

4. Support de données selon la revendication 1, **caractérisé** en ce que le substrat (10), est pourvu, sur le côté opposé aux surfaces de contact (2), d'une feuille (6) d'adhésif par fusion, et le ruban de film (5) est emprisonné entre le module (3) de circuit intégré et la feuille d'adhésif (6).

5. Elément de support à monter dans un support de données, se composant d'un substrat qui porte un module de circuit intégré, qui est relié par des lignes conductrices à des éléments de contact prévus sur le substrat, **caractérisé** en ce qu'il est disposé, au-dessous du module de circuit intégré (3), un ruban de film (5) dont la largeur est à peu près celle du module (3) de circuit intégré et dont la longueur est au moins égale à celle de ce module et qui se compose d'une matière dont la possibilité de déformation est plus élevée que celle du chlorure de polyvinyle ou PVC.

6. Elément de support Selon la revendication 5, pourvu d'une feuille d'adhésif par fusion qui est disposée sur la surface du substrat opposée aux surfaces de contact, **caractérisé** en ce que le ruban de film (5) est prévu dans la zone du module à circuit intégré (3), entre ce module de circuit intégré (3) et la feuille d'adhésif par fusion (6), et s'étend sur toute la longueur du substrat.

7. Elément de support selon la revendication 6, **caractérisé** en ce que le module (3) de circuit intégré est disposé dans un évidement (11) du substrat (10) et en ce que les lignes conductrices (4) allant vers ce module (3) de circuit intégré sont guidées dans la zone de l'évidement (11) d'une manière telle qu'elles soient situées au-dessous au ruban de film (5).

8. Elément de support selon la revendication 7, **caractérisé** en ce qu'un autre ruban de film (32), dont la largeur est à peu près égale à celle de l'évidement (11) et dont la longueur est au moins égale à celle de ce dernier, et qui passe audessus du substrat (10) entre les rangées disposées parallèlement des surfaces de contact (2), est prévu sur la surface du substrat (10) qui porte les surfaces de contacts (2).

9. Elément de support, pour la réalisation de supports de données, se composant d'un substrat qui porte un module de circuit intégré, qui est relié par des lignes conductrices à des éléments de contact prévus sur le substrat, **caractérisé** en ce que le module de circuit intégré (3) est disposé sur un côté du substrat (10) et en ce que les lignes conductrices (4) partent des points de connexion (43) du module de circuit intégré à travers des ouvertures (40) ménagées dans le substrat (10) et sont reliés aux surfaces de contact (2) qui sont situées sur le côté du substrat (10) opposé au module de circuit intégré.

10. Elément de support selon la revendication 9, **caractérisé** en ce que les points de connexion (43) du module (3) de circuit intégré sont placés sur celui-ci d'une manière telle que les ouvertures (40) ménagées dans le substrat (10) soient recouvertes par ce module de circuit intégré sur le côté opposé aux surfaces de contact (2).

11. Elément de support selon la revendication 10, **caractérisé** en ce que les points de connexion (43) sont disposés au centre de la surface du module (3) de circuit intégré.

12. Procédé de fabrication d'un élément de support selon la revendication 6, **caractérisé** par les étapes de procédé consistant à:
- préparer un film de substrat, revètu de modules de circuits intégrés,
- amener, sur le côté du film du substrat, opposé aux surfaces de contact dans la zone du module de circuit intégré, un ruban de film à haut pouvoir de déformation, dont la largeur est à peu près égale à celle du module de circuit intégré,
- amener, sur le côté du film du substrat opposé aux surfaces de contact, une feuille d'adhésif par fusion d'une manière telle que la fauille d'adhésif par fusion recouvre aussi bien le ruban de film (5) que des parties de la surface du film du substrat,
- fixer la bande de film par liaison de la feuille d'adhésif par fusion avec le film de substrat, la feuille d'adhésif par fusion étant reliée au film au moins dans la zone de bord du module de circuit intégré.

13. Procédé selon la revendication 12, **caractérisé** en ce qu'un ruban de film additionnel, dont la largeur correspond à peu près à l'évidement du substrat et qui s'étend entre les rangées, disposées en parallèle, des surfaces de contact, est monté sur le côté du film qui comporte las surfaces de contact.

14. Installation de mise en oeuvre du procédé selon la revendication 12, **caractérisé** par:
- un dispositif de collage (26, 27) et d'entraînement (29, 31, 34), servant à transporter et attacher, avec au moins un ruban de film, un film de substrat (10) garni de modules (3) de circuits intégrés,
- un premier dispositif (20) de préparation du film de substrat (10), garni des modules de circuit intégré,
- un deuxième dispositif (22, 24), qui amène au film dans la zone de l'installation de collage (26, 27), un premier ruban (7) à haut pouvoir de déformation, dont la largeur correspond à peu près à la largeur du module (3) de circuit intégré,
- un troisième dispositif (23, 25) qui amène au film (10), dans la zone de l'installation de collage (26, 27), une feuille d'adhésif par fusion (6),
- un dispositif (21) qui emmagasine temporairement le film (10) pourvu d'au moins un ruban de film.

15. Installation selon la revendication 14, **caractérisé** en ce que le deuxième dispositif se compose d'un rouleau de réserve et d'un rouleau de changement de sens (22, 24), servant à amener un ruban de film (5) en polyéthylène à l'installation de collage (26, 27).

16. Installation selon la revendication 14, **caractérisé** en ce que le troisème dispositif se compose d'un rouleau de réserve et d'un rouleau de changement de sens (23, 25) servant à amener la feuille d'adhésif par fusion (6) à l'installation de collage (26, 27).

17. Dispositif selon la revendication 14, **caractérisé** en ce qu'il est prévu un quatrième dispositif (33) qui est disposé face au deuxième et au troisième dispositifs (22, 24, 23, 25) et au moyen duquel un autre ruban de film (32) peut être amené au film de substrat (10).
